# EUROPEAN PATENT APPLICATION

(11) **EP 4 113 581 A1**
(43) Date of publication of application: **04.01.2023**
(21) Application number: 22181471.8
(22) Date of filing: 28.06.2022
(51) Int. Cl.: H01L 21/28, H01L 21/268, H01L 29/417, H01L 21/336, H01L 21/329, H01L 29/78, H01L 29/872, H01L 29/16, H01L 29/06

(54) **PROCESS FOR MANUFACTURING A VERTICAL CONDUCTION SILICON CARBIDE ELECTRONIC DEVICE AND VERTICAL CONDUCTION SILICON CARBIDE ELECTRONIC DEVICE**

(30) Priority: 29.06.2021 IT 202100017060
(71) Applicant: STMicroelectronics S.r.l., 20864 Agrate Brianza (MB) (IT)
(72) Inventor: BADALA', Paolo, 95024 Acireale (CT) (IT); BASSI, Anna, 95030 Gravina di Catania (CT) (IT); BOSCAGLIA, Massimo, 95037 San Giovanni La Punta (CT) (IT); SCUDERI, Valentina, 95127 Catania (IT); FRANCO, Giovanni, 95039 Viagrande (CT) (IT)
(74) Representative: Studio Torta S.p.A.

(57) **Abstract**

For the manufacturing of a vertical conduction silicon carbide electronic device, a metal layer (20) is deposited on a wafer (5) that has silicon carbide, wherein the metal layer forms a contact face (22). Laser annealing the contact face (22) with a laser beam (33) causes the metal layer to react with the wafer, forming a silicide layer (50). The laser beam has a footprint (35) having a size (L_{p,X}, L_{p,Y}, W_{X}, W_{Y}). To laser anneal the contact face, a first portion (47) of the contact face is irradiated, the footprint (35) of the laser beam is moved by a step (D_{X}, D_{Y}) smaller than the size of the footprint, and a second portion (48, 49) of the contact face is irradiated, thereby causing the first portion and the second portion of the contact face to overlap.

## Description

The present invention is relative to a process for manufacturing a vertical conduction silicon carbide electronic device and to a vertical conduction silicon carbide electronic device.

As known, silicon carbide (SiC) electronic devices such as Junction Barrier Schottky (JBS) diodes, Merged PiN Schottky (MPS) diodes and MOSFET transistors, have better performances than silicon electronic devices, in particular for power applications, wherein high operating voltages or other specific operating conditions, such as high temperature, are employed.

A silicon carbide electronic device for power applications, hereinafter indicated as power device, comprises a silicon carbide body, a front metal region and a back metal region. In use, a current may flow through the silicon carbide body between the front metal region and the back metal region.

It is known to obtain the power device from a silicon carbide wafer having a front surface and a back surface, in one of its polytypes, such as 3C-SiC, 4H-SiC and 6H-SiC.

During initial manufacturing steps, devices like transistors, diodes, resistors, etc. are generally formed in the silicon carbide body from the front surface. Then, the front metal region is formed on the front surface to mutually interconnect the integrated devices as well as to allow connection of the power device with external circuit components and/or stages.

In addition, the back surface of the wafer is processed, so as to form the back metal region.

To this end, a metal layer, e.g. nickel or titanium, is deposited on the back surface.

Then, a laser beam is used to heat the metal layer and cause the metal layer to fully react with the silicon carbide atoms of the wafer, thereby forming a silicide layer, e.g. titanium or nickel silicide.

In detail, the used laser beam has a spot having an area that is much smaller than the area of the back surface of the wafer. Therefore, in order to entirely expose the back surface, a step-and-repeat approach is used, wherein a first laser shot exposes a first portion of the back surface, the laser beam (or the wafer) is moved, and a second laser shot exposes a second portion of the back surface.

In order to maximize the throughput of the manufacturing process, it is known to move the laser beam so that the spots of adjacent laser shots have possibly no overlap on the back surface. In practice, the laser beam is moved, between two consecutive shots, by a quantity that is approximately equal to the size of the spot.

Subsequently, a metallization layer is deposited on the silicide layer.

After final manufacturing steps including dicing, the power device is obtained.

The Applicant has verified that, in some cases, the silicide layer of such known power devices has a low mechanical stability. In fact, during some reliability tests, it has been observed that the silicide layer has a high probability of delamination from the silicon carbide body or mechanical fracture, thereby causing failure of the power device.

The aim of the present invention is to overcome the disadvantages of the prior art.

According to the present invention, a process for manufacturing a vertical conduction silicon carbide electronic device and a vertical conduction silicon carbide electronic device are provided, as defined in the attached claims.

For a better understanding of the present invention, a non-limiting embodiment is now described, with reference to the attached drawings, wherein:
- figure 1 shows a cross-section of a work body comprising a silicon carbide wafer, according to the present manufacturing process;
- figure 2 is a top plan view of the work body of figure 1;
- figure 3 is a cross-section of the work body of figure 1 in a subsequent manufacturing step;
- figure 4 is a cross-section of the work body of figure 3 in a subsequent manufacturing step comprising a laser annealing step;
- figures 5 and 6 show an energy profile of a footprint of a laser beam along two different directions;
- figure 7 shows a perspective view of the energy profile of the footprint of figures 5 and 6;
- figure 8 shows a top-plan view of the footprint of the laser beam of figures 5-7 formed on the work body, during the laser annealing step of figure 4;
- figures 9 and 10 are schematic representations of a scanning method of the laser annealing step of figure 4;
- figures 11 and 12 are respectively a cross-section and a top plan view of the work body of figure 4 after the laser annealing step;
- figure 13 shows a cross-section of the work body of figures 11 and 12 in a subsequent manufacturing step;
- figure 14 is a cross-section of the present electronic device; and
- figure 15 is an exemplificative micrograph of a surface of the present electronic device.

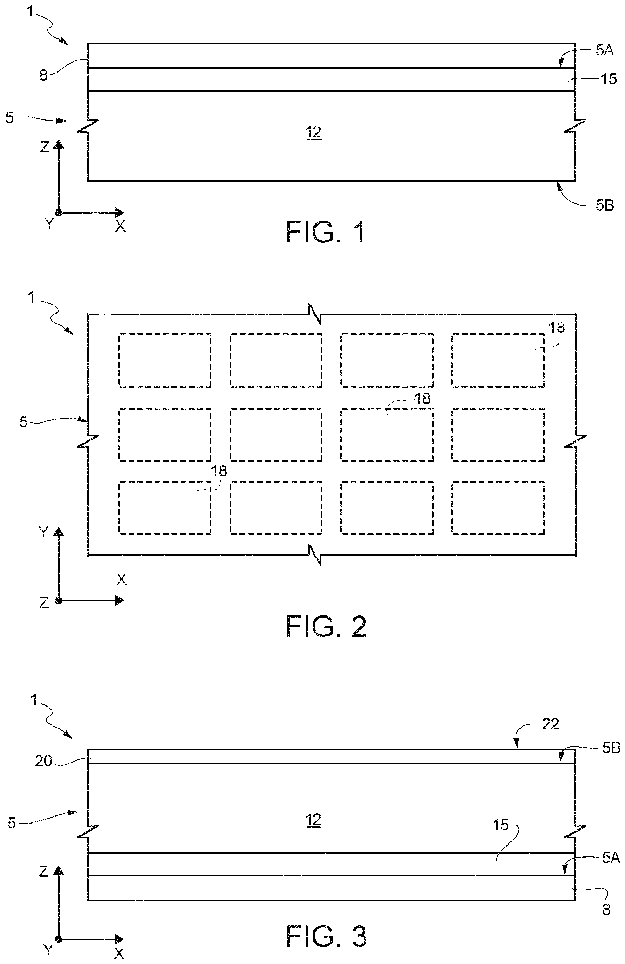

Figures 1 and 2 show a work body 1 in a Cartesian reference system XYZ comprising a first axis X, a second axis Y and a third axis Z.

The work body 1 has already been subject to first manufacturing steps.

The work body 1 is formed by a wafer 5 of silicon carbide (SiC) in one of its polytypes, such as 3C-SiC, 4H-SiC and 6H-SiC, having a first surface 5A and a second surface 5B, and by a connection structure layer 8 extending on the first surface 5A of the wafer 5.

The wafer 5 comprises a work substrate 12, which forms the second surface 5B of the wafer 5, and a device layer 15, which forms the first surface 5A of the wafer 5 and extends directly on the work substrate 12.

The device layer 15 may be a portion of the work substrate 12 or may be an epitaxial layer grown on the work substrate 12.

The device layer 15 comprises current conduction zones, here not shown, whose structure, number and configuration depend on the specific application.

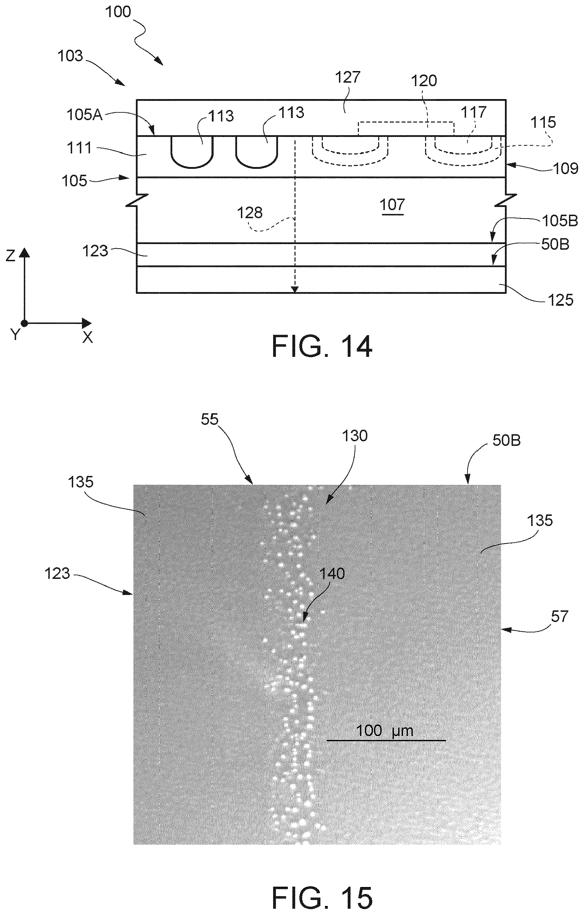

For example, the device layer 15 may comprise a drift layer and one or more implanted regions which may form, for example, source regions and body regions, depending on the specific application, examples whereof are shown for illustrative purposes in figure 14.

In an embodiment, the device layer 15 may also comprise gate structures. In another embodiment, the device layer 15 may be a multilayer, with different device structures integrated in the various layers.

The connection structure layer 8 comprises one or more metal layers that form an electrical interconnect structure for the device layer 15.

According to an embodiment, the connection structure layer 8 may also comprise one or more layers of insulating materials, forming passivation structures.

The device layer 15 and the connection structure layer 8 form at least one die portion, here a plurality of die portions 18.

Each die portion 18 is intended to form a respective electronic device, after dicing the work body 1.

Each die portion 18 has a die area, which occupies a respective portion of the area of the first surface 5A of the wafer 5.

In figure 2, for simplicity, the die portions 18 are schematically indicated by dashed lines.

In detail, in this embodiment, each die portion 18 has a rectangular shape in top plan view. By way of example only, the die area may be approximately of few millimeters squared, for example approximately 4 mm by 5 mm.

Subsequently, figure 3, the work body 1 is flipped upside down and a contact layer 20 is deposited on the second surface 5B of the wafer 5, forming a contact surface 22 of the work body 1.

The contact layer 20 is a metal material such as nickel, titanium or an alloy of nickel and silicon, and has a thickness, measured parallel to the third axis Z, comprised for example between 20 nm and 150 nm, in particular of about 100 nm.

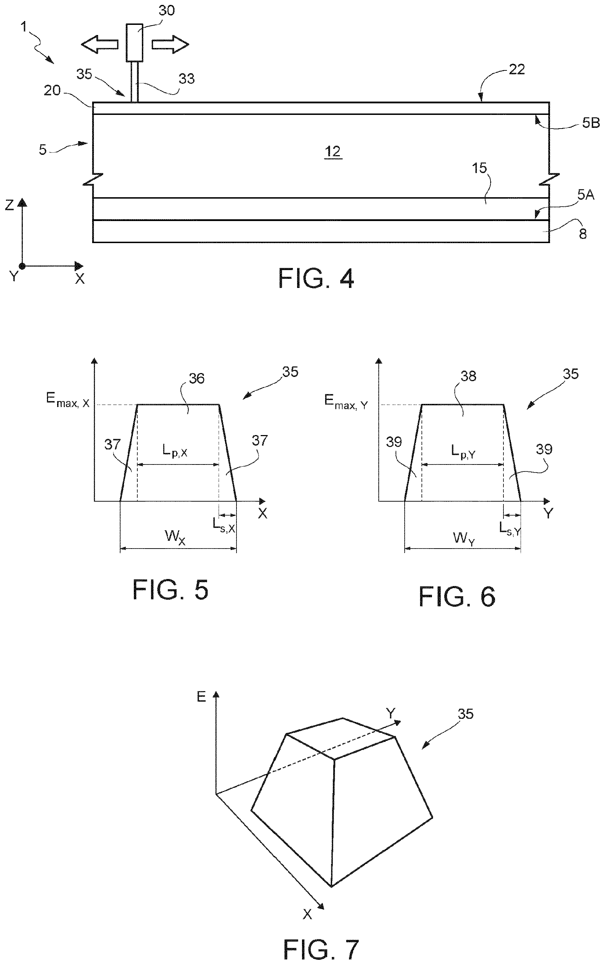

Then, figure 4, the work body 1, in particular the contact layer 20, undergoes a laser annealing step.

In detail, a laser source 30 is used to generate a light beam 33 and focus the light beam 33 on the contact surface 22.

The light beam 33 has an energy density higher than 3 J/cm², for example comprised between 3.4 J/cm² and 4.8 J/cm², in particular of 4.0 J/cm².

The light beam 33 has a wavelength comprised, for example, between 290 nm and 370 nm, in particular of 310 nm.

The light beam 33 may be a pulsed light beam having a duration comprised, for example, between 100 ns and 300 ns, in particular of 160 ns.

The light beam 33 has a beam footprint 35 on the contact surface 22.

Figures 5 and 6 show an energy profile of the beam footprint 35, parallel to the first axis X and, respectively, to the second axis Y.

In detail (figure 5), the beam footprint 35 has a first width Wₓ parallel to the first axis X and comprises a first plateau region 36 having a first energy E_{max,x} and a first plateau length L_{p,x}, and two first sloped regions 37, each having a first slope length L_{s,x}, wherein the beam energy decreases from the first energy E_{max,x} to zero.

In particular, the beam energy may decrease linearly in the first sloped regions 37, from the first energy E_{max,x} to zero.

Moreover, in this embodiment, the first energy E_{max,x} is constant.

The first width Wₓ may be comprised, for example, between 8 mm and 36 mm, in particular may be about 10 mm.

In this embodiment, the first slope length L_{s,x} is much smaller than the first plateau length L_{p,x}. For example, the first slope length L_{s,x} is comprised between 0,5% and 5% of the first plateau length L_{p,x}, in particular about 3% of the first plateau length L_{p,x}.

For example, the first slope length L_{s,x} may be comprised between 50 µm and 500 µm, in particular may be 300 µm.

Accordingly, in a first approximation, the first plateau length L_{p,x} is about the same as the first width Wₓ of the beam footprint 35.

In addition (figure 6), the beam footprint 35 has a second width Wy parallel to the second axis Y and comprises a second plateau region 38 having a second energy E_{max,Y} and a second plateau length L_{p,Y}, and two second sloped regions 39, each having a second slope length L_{s,Y}, wherein the beam energy decreases from the second energy E_{max,Y} to zero.

In particular, here, the beam energy may decrease linearly in the second sloped regions 39, from the second energy E_{max,Y} to zero.

Moreover, in this embodiment, the second energy E_{max,Y} is constant and equal to the first energy E_{max,X}.

The second width Wy may be comprised, for example, between 8 mm and 36 mm, in particular may be about 10 mm.

In this embodiment, also the second slope length L_{s,Y} is much smaller than the second plateau length L_{p,Y}. For example, the second slope length L_{s,Y} is comprised between 0,5% and 5% of the second plateau length L_{p,Y}, in particular about 3% of the second plateau length L_{p,Y}.

For example, the second slope length L_{s,Y} may be comprised between 50 µm and 500 µm, in particular may be 300 µm.

Accordingly, in a first approximation, the second plateau length L_{p,Y} is about the same as the second width Wy of the beam footprint 35.

In this embodiment, the beam footprint 35 has the same energy profile as the ones shown in figures 5 and 6 for every section parallel to the first axis X and, respectively, to the second axis Y.

Moreover, in this embodiment, the energy profile of the beam footprint 35 along any direction parallel to the first axis X is equal to the energy profile along any direction parallel to the second axis Y. Therefore, a 3-dimesional representation of the energy profile of the beam footprint 35 is a truncated pyramid, as shown in the perspective view of figure 7.

The footprint 35 may be obtained for example using the laser LT-3100 manufactured by SCREEN Semiconductor Solutions Co., Ltd.

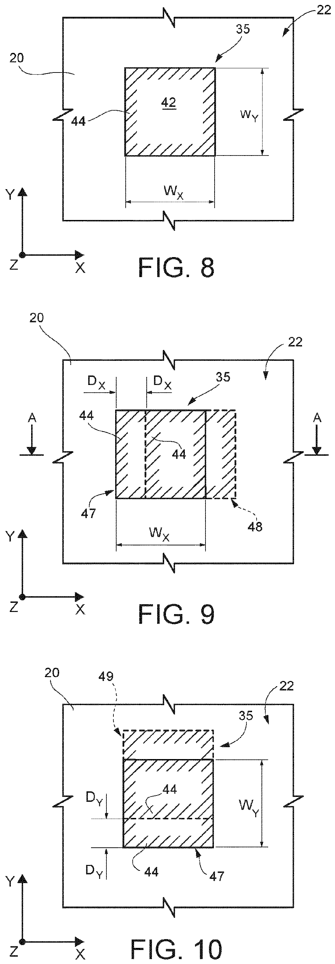

The beam footprint 35 forms a polygonal shape on the contact surface 22, in particular a squared shape, as shown in figure 8, whose sides have the first width Wx along the first axis X and the second width Wy along the second axis Y.

In practice, for each portion of the contact surface 22 that is exposed by the laser beam 33, the beam footprint 35 forms a central region 42, which is irradiated with a constant energy and corresponds to the first plateau region 36 and the second plateau region 38, and a gradient region 44, which is irradiated with a non-constant energy and corresponds to the first sloped regions 37 and the second sloped regions 39, wherein the gradient region 44 surrounds the central region 42.

In figures 8-10, for clarity, the gradient region 44 is indicated with oblique lines.

During the annealing step of figure 4, the laser source 30 focuses the laser beam 33 on a first portion 47 of the contact surface 22 (figure 9).

The laser beam 33 is absorbed by the contact layer 20 and by part of the work substrate 12. The absorbed light generates heat locally, i.e. immediately under the first portion 47 of the contact surface 22, for example to a depth of few microns from the contact surface 22.

The generated heat makes the contact layer 20 and the work substrate 12 to react locally, at a respective portion of the second surface 5B of the wafer 5, forming a silicide, for example nickel silicide or titanium silicide.

In order to cause the reaction of the entire contact layer 20 with the work substrate 12, the contact surface 22 is scanned using a step-and-repeat approach.

In detail, the work body 1 is moved with respect to the laser beam 33 so that the laser beam 33 is focused on a second portion 48 of the contact surface 22 (figure 9).

For clarity, in figure 9, the second portion 48 of the contact surface 22 is drawn by a dashed line.

The second portion 48 of the contact surface 22 partially overlaps the first portion 47 of the contact surface 22 and partially extends next to the first portion 47 of the contact surface 22 along a first scanning line A parallel to the first axis X.

In detail, the relative movement of the work body 1 with respect to the laser source 30 causes the beam footprint 35 to move by a first shift step D_{X} along the first scanning line A. Therefore, also the second portion 48 of the contact surface 22 is shifted with respect to the first portion 47 of the contact surface 22 along the first scanning line A, on the right in figure 9, by the first shift step Dx.

The first shift step D_{X} is smaller than the first width W_{X} of the beam footprint 35.

In detail, the first shift step Dx is a fraction of the first width W_{X}, for example comprised between one tenth and one half of the first width Wx, in particular about one fourth of the first width W_{X}.

For example, in one embodiment, the first width Wx may be 10 mm and the first shift step D_{X} may be smaller than 2.5 mm.

Subsequently, the laser source 30 focuses the laser beam 33 on subsequent portions of the contact surface 22 along the first scanning line A throughout the entire length of the contact surface 22 along the first scanning line A.

Subsequently, the laser beam 33 scans the contact surface 22 along a second scanning line, here not shown, parallel to the first scanning line A and shifted along the second axis Y to expose a third portion 49 of the contact surface 22, as shown for example in figure 10, where the third portion 49 of the contact surface 22, for clarity, is drawn with a dashed line.

The third portion 49 of the contact surface 22 partially overlaps the first portion 47 of the contact surface 22 and partially extends next to the first portion 47 of the contact surface 22 along a direction parallel to the second axis Y.

In detail, the relative movement of the work body 1 with respect to the laser source 30 causes the beam footprint to move by a second shift step Dy in a direction parallel to the second axis Y with respect to the position of the first portion 47. Therefore, the third portion 49 of the contact surface 22 is shifted by the second shift step Dy, parallel to the second axis Y, from the first portion 47.

The second shift step Dy is smaller than the second width W_{Y}. In detail, the second shift step Dy is a fraction of the second width Wy, for example comprised between one tenth and one half of the second width Wy, in particular about one fourth of the second width Wy.

For example, in one embodiment, the second width Wy may be 10 mm and the second shift step Dy may be smaller than 2.5 mm.

By repeating the steps discussed above, the entire contact surface 22 is scanned by the laser beam 33.

In general, adjacent irradiated portions of the contact surface 22 may be shifted by steps different from the first shift step D_{X} and the second shift step Dy.

For example, the first shift step Dx may be different from the second shift step Dy.

In addition, the first shift step Dx or the second shift step D_{Y} may be varied along a same scan line or among different scan lines. This may allow to tune the distance between adjacent gradient regions 44, for example to increase (or decrease) the density of gradient regions 44 in specific portions of the contact surface 22.

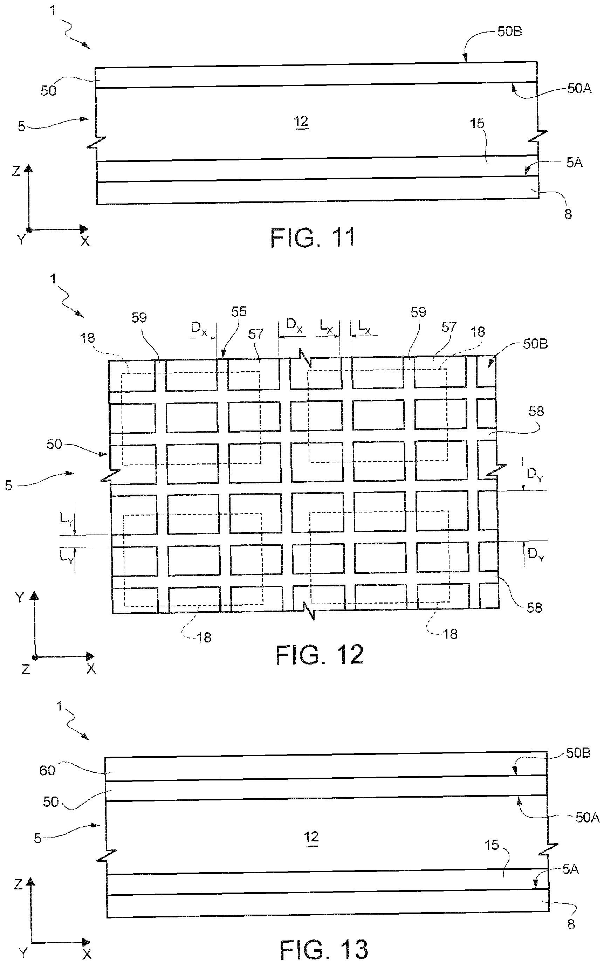

Figure 11 shows the work body 1 after the contact surface 22 has been completely exposed by the laser beam 33, thereby causing the complete reaction of the contact layer 20 with the work substrate 12 and formation of an ohmic layer 50.

The ohmic layer 50 is of silicide and extends between a first surface 50A, which corresponds to the second surface 5B of the wafer 5, and a second surface 50B, which corresponds to the contact surface 22.

Generally, the ohmic layer 50 is thicker than the contact layer 20, since also part of the work substrate 12 has reacted to form the ohmic layer 50.

Figure 12 shows a top plan view of the second surface 50B of the ohmic layer 50, according to an idealized representation. By virtue of the laser annealing step of figure 4, the ohmic layer 50 comprises a rough region 55 and a plurality of smooth regions 57.

The smooth regions 57 correspond to the portions of the contact surface 22 that have been exposed only to the first plateau region 36 and the second plateau region 38 of the beam footprint 35, i.e. that have received a spatially uniform energy.

The rough region 55 corresponds to the gradient portions 44 of the contact surface 22, i.e. to the portions of the contact surface 22 that have received a spatially non-uniform energy.

The gradient of energy of the gradient regions 44 generates in fact also a thermal gradient during the laser annealing step of figure 4, which in turn causes the rough region to have an increased roughness with respect to the smooth regions 57, as also discussed below with reference to figure 15.

Again with reference to figure 12, in this embodiment, the rough region 55 is a grid formed by a plurality of horizontal stripes 58, parallel to the first axis X, and a plurality of vertical stripes 59, parallel to the second axis Y.

Each horizontal stripe 58 has a width Lx, parallel to the first axis X, which approximately corresponds to the first slope length L_{s,X} of the beam footprint 35 and extends at a distance from an adjacent horizontal stripe 58 that is approximately equal to the first shift step Dx.

Each vertical stripe 59 has a width Ly, parallel to the second axis Y, which approximately corresponds to the second slope length L_{s,Y} of the beam footprint 35 and extends at a distance from an adjacent vertical stripe 59 that is approximately equal to the second shift step Dy.

By changing the first shift step Dx and the second shift step Dy, the number of horizontal stripes 58 and vertical stripes 59 may be changed.

In this embodiment, as visible in figure 12, the first shift step D_{X} and the second shift step Dy have been chosen so that each die portion 18 has two horizontal stripes 58 and two vertical stripes 59.

In figure 13, a metallization layer 60 is deposited on the second surface 50B of the ohmic layer 50. The metallization layer 60 may be a single metal layer or a stack of different metal layers, for example Ti/NiV/Ag.

The metallization layer 60 is useful for subsequent manufacturing steps, for example assembling processes such as sintering and diffusion soldering.

The work body 1 is then subject to known final manufacturing steps, such as dicing, thereby forming an electronic device 100 (figure 14) for each die portion 18.

The electronic device 100 comprises a die 103 including a body 105 having a first surface 105A, which corresponds to the first surface 5A of the wafer 5, and a second surface 105B, which corresponds to the first surface 50A of the ohmic layer 50.

The body 105 comprises a substrate 107 (corresponding to the work substrate 12 and forming the second surface 105B) and a device region 109 (corresponding to the device layer 15 and forming the first surface 105A).

The device region 109, as discussed above for the device layer 15, accommodates functional regions of various kind and dimensions, according to the specific type of the electronic device 100 and the specific application.

By way of example, the electronic device 100 may be a JBS or an MPS diode. In this case, as shown in figure 14 by way of example, the device region 109 forms a drift region 111 of a first conductivity type, e.g. N-type, accommodating two implanted regions 113 of a second conductivity type, e.g. P-type.

As an alternative, as also shown as an example in figure 14, the electronic device 100 may be a MOSFET device. In this case, the drift region 111 accommodates body regions 115 of the second conductivity type, source regions 117 of the first conductivity type and insulated gate regions 120 of dielectric material (represented with dashed lines in figure 14).

The die 103 comprises an ohmic connection region 123, corresponding to the ohmic layer 50, extending on the second surface 105B of the body 105 and forming a metallization contact surface, which corresponds to the second surface 50B of the ohmic layer 50 and therefore it is indicated by the same reference number.

The die 103 also comprises a back metallization region 125 corresponding to the metallization layer 60 and extending on the metallization contact surface 50B.

The die 103 further comprises a connection structure region 127 corresponding to the connection structure layer 8, extending on the first surface 105A of the body 105.

In detail, the device region 109 and the connection structure region 127 correspond to a respective die portion 18 (figure 2).

In use, the electronic device 100 has a current path 128, schematically represented by a dashed arrow in figure 14, which extends between the connection structure region 111 and the back metallization region 125, through the body 105.

In use, a current may flow through the current path 128, depending on the specific structure of the device region 109, i.e. on the type of the electronic device 100.

The ohmic connection region 123 shows a high mechanical stability.

The ohmic connection region 123 comprises a rough region and one or more smooth regions. The rough region and the smooth regions correspond to the portion of the rough region 55 and, respectively, to the smooth regions 57 within the respective die portion 18 of figure 12. Therefore, hereinafter, the rough region of the ohmic connection region 123 is indicated by the same reference number as the rough region 55 of figure 12 and the smooth regions of the ohmic connection region 123 are indicated by the same reference number as the smooth regions 57 of figure 12.

The shape of the rough region 55 of the ohmic connection region 123 depends on the first and the second shift step Dx, Dy, and on the first width W_{X}, the second width Wy, the first slope length L_{s,X} and the second slope length L_{s,Y} of the beam footprint 35. Accordingly, the rough region 55 of the ohmic connection region 123 is formed by portions of the horizontal stripes 58 and portions of the vertical stripes 59.

In detail, in this embodiment, the rough region 55 of the ohmic connection region 123 is formed by portions of two adjacent horizontal stripes 58 and portions of two adjacent vertical stripes 59.

Depending on the first and the second shift step D_{X}, Dy, and on the first width W_{X}, the second width W_{Y}, the first slope length L_{s,X} and the second slope length L_{s,Y} of the beam footprint 35, the percentage of the ohmic connection region 123 that is formed by the smooth regions 57 (and accordingly by the rough region 55) may be varied.

The rough region 55 of the ohmic connection region 123 has a non-uniform thickness along the third axis Z.

The rough region 55 of the ohmic connection region 123 has, at the second surface 105B of the body 105 and at the second surface 50B of the ohmic connection region 123, a higher roughness than the smooth regions 57 of the ohmic connection region 123.

Figure 15 is an exemplificative zoomed-in micrograph of a portion of the second surface 50B of the ohmic connection region 123, showing the effect of the gradient regions 44 during the laser annealing of figure 4.

The micrograph of figure 15 shows a portion 130 of the rough region 55 of the ohmic connection region and two portions 135 of the smooth region 57. The portion 130 of the rough region 55, which corresponds for example to a portion of an horizontal stripe 58 or of a vertical stripe 59, is formed by a plurality of protrusions 140 of silicide, each having a diameter comprised for example between 0.5 µm and 2 µm.

The Applicant has verified that the protrusions 140 increase the mechanical robustness of the ohmic connection region 123. The electronic device 100 is therefore less subject to mechanical defects such as fracture and delamination of the ohmic connection region 123.

In particular, a shear test of the electronic device 100, performed by the Applicant after subjecting test devices to one hundred thermal cycles, shows an average increase of the shear strength of the electronic device 100 even up to 156% with respect to a case wherein the electronic device 100 has no overlap portions.

At the same time, the ohmic connection region 123 ensures a good electrical contact, in particular an ohmic contact, with the substrate 107. Therefore, the electronic device 100 also maintains good electrical properties.

It is clear that the present manufacturing method and the corresponding electronic device may be subject to modifications and variations without departing the scope of the present invention, as defined in the attached claims.

For example, the beam footprint 35 may have a different shape such as rectangular, circular or any other shape.

In addition, the energy profile along the first axis may be different from the energy profile along the second axis Y. For example, the spatial trend of the first and the second sloped regions 37, 39 may be different, such as non-linear.

Moreover, a higher number of laser shots or pulses may be used to expose each irradiated portion of the contact surface 22. For example, two to five laser shots or pulses may be used.

In the annealing step of figure 4, the step-and-repeat type of scanning may be achieved either by moving the work body 1, by moving the laser source 30, by deflecting the laser beam 33 or a combination thereof, depending on the specific application.

Moreover, the shape of the rough region 55 of figure 12 (and accordingly also of the rough region 55 of the ohmic connection layer 123 of the electronic device 100) may be different. A different number of horizontal and vertical stripes 58, 59 may be comprised in a die portion 18. For example, the density of horizontal and vertical stripes 58, 59 may be so high that the ohmic layer 50 (and therefore also the ohmic connection region 123 of the electronic device 100) is approximately entirely formed by a rough region.

Alternatively, the rough region 55 may have a shape different from a grid, for example the rough region 55 may form a non-regular pattern such as a plurality of separated portions with increased roughness.

## Claims

1. A process for manufacturing a vertical conduction silicon carbide electronic device, the process comprising:
- depositing, on a wafer (5) comprising silicon carbide, a metal layer (20), the metal layer forming a contact face (22); and
- laser annealing the contact face (22) with a laser beam (33), the laser beam having a footprint (35) having a size (L_{p,X}, L_{p,Y}, W_{X}, W_{Y}), thereby causing the metal layer to react with the wafer, forming a silicide layer (50);
wherein laser annealing the contact face comprises irradiating a first portion (47) of the contact face, moving the footprint (35) of the laser beam by a step (D_{X}, Dy) smaller than the size of the footprint and irradiating a second portion (48, 49) of the contact face, thereby causing the first portion and the second portion of the contact face to overlap, wherein the footprint (35) forms, on the contact face (22), a gradient region (37, 39, 42) having a spatially varying energy, wherein the gradient region causes the formation of a rough region (55, 58, 59) of the silicide layer (50) .

2. The process according to the preceding claim, wherein the rough region comprises a plurality of irregularly arranged protrusions (140) having a diameter in the range 0.5 µm-2 µm.

3. The process according to claim 1 or 2, wherein the gradient region has a size (L_{s,X}, L_{s,Y} ) smaller than the size (L_{p,X}, L_{p,Y}, W_{X}, Wy) of the footprint (35) .

4. The process according to the preceding claim, wherein the size (L_{s,X}, L_{s,Y} ) of the gradient region (37, 39, 42) is comprised between 0.5% and 5% of the size (L_{p,X}, L_{p,Y}, W_{X}, W_{Y}) of the footprint (35) .

5. The process according to any of the preceding claims, wherein the step (D_{X}, D_{Y}) is comprised between one tenth and one half of the size (L_{p,X}, L_{p,Y}, W_{X}, W_{Y}) of the footprint (35) .

6. The process according to any of the preceding claims, wherein the footprint (35) has a polygonal shape having a side comprised between 8 mm and 36 mm.

7. The process according to any of the preceding claims, wherein the laser beam has an energy density comprised between 3.4 J/cm² and 4.8 J/cm².

8. The process according to any of the preceding claims, wherein the laser beam is a pulsed beam having a duration comprised between 100 ns and 300 ns.

9. The process according to any of the preceding claims, wherein the laser beam has a wavelength comprised between 290 nm and 370 nm.

10. The process according to any of the preceding claims, wherein laser annealing comprises scanning the entire contact face (22) with the laser beam (33) using a step-and-repeat type of scanning.

11. The process according to any of the preceding claims, further comprising depositing a metallization layer (60) on the silicide layer.

12. The process according to any of the preceding claims, wherein the silicide layer is formed on a first conduction terminal surface (5B) of the wafer, the wafer also having a second conduction terminal surface (5A) and comprising a device layer (15) that forms the second conduction terminal surface, the process further comprising forming electrically conductive device regions (113, 115, 117) in the device layer, and forming a connection structure layer (8) on the second conduction terminal surface.

13. A vertical conduction silicon carbide electronic device formed in a die (103) comprising:
- a body (105) of silicon carbide; and
- a contact region (123) of silicide extending on the body and forming a connection surface (50B),
wherein the contact region comprises a first rough portion (58, 59, 130) and a second rough portion (58, 59, 130), the first rough portion extending at a distance from the second rough portion, the first rough portion and the second rough portion including a plurality of irregularly arranged protrusions (140) of silicide.

14. The device according to the preceding claim, wherein the first rough portion and the second rough portion each have a width comprised between 50 µm and 500 µm, and wherein the distance between the first rough portion and the second rough portion is smaller than 2.5 mm.

15. The device according to claim 13 or 14, wherein each protrusion has a diameter comprised between 0.5 µm and 2 µm.

16. The device according to any of claims 13-15, wherein the contact region extends on a first conduction terminal surface (105B) of the body and the body (105) also has a second conduction terminal surface (105A), the device further comprising a device region (109) extending in the body and forming the second conduction terminal surface, and a connection structure region (111) extending on the second conduction terminal surface.
